# EUROPEAN PATENT APPLICATION

(11) **EP 4 648 236 A1**
(43) Date of publication of application: **12.11.2025**
(21) Application number: 24174762.5
(22) Date of filing: 08.05.2024
(51) Int. Cl.: H01S 5/0687, H01S 5/00, H01S 5/06

(54) **WAVELENGTH CONTROLLER AND SYSTEM FOR A TUNABLE LASER**

(71) Applicant: Stichting IMEC Nederland, 5656 AE Eindhoven (NL)
(72) Inventor: ZHANG, Xuebing, 5614 GA Eindhoven (NL); OLDENBEUVING, Ruud, 5651 HE Eindhoven (NL)
(74) Representative: AWA Sweden AB

(57) **Abstract**

The invention concerns a wavelength controller (100) for a tunable laser (10). The wavelength controller (100) is configured to receive an input signal and in response thereto generate a control signal for tuning the wavelength of the laser. The wavelength controller (100) is configured to receive at least part of the output of the laser (10) as an input signal. The wavelength controller (100) includes an interferometer-based circuit (110) configured to generate phase-shifted intensity values based on the input signal. The wavelength controller (100) includes a vector-based signal synthesizer (120) configured to generate a complex vector-based signal based on the phase-shifted intensity values and to compute at least one vector-representing quantity based on the complex vector-based signal. The vector-representing quantity or quantities is/are substantially linearly correlated with the wavelength. The wavelength controller (100) includes a control signal generator (130) configured to generate the control signal at least partly based on said at least one vector-representing quantity.

## Description

### Technical field

The present description relates to a wavelength controller for a tunable laser, and a laser system comprising a wavelength controller and a tunable laser.

### Background

Wavelength controllers and wavelength lockers (WLL) are integral components in optical communication, specifically in stabilizing the wavelength output of lasers. A wavelength locker, in essence, acts to ensure precision in optical communication systems and ensure the accuracy and consistency of laser performance, e.g., enabling effective communication systems.

Current optical transceivers, which are commonly utilized in high-speed optical fiber communications such as telecommunications and data centers, integrate all necessary components on a single chip. These components include lasers and modulators, amplifiers, and detectors. For telecom applications like Dense Wavelength Division Multiplexing (DWDM), there is a strict requirement for laser wavelength/frequency stability to avoid inter-channel crosstalk. For example, coherent transmission in ITU G.698.2 requires laser frequency stability below ±1.8GHz.

In the prior art, Multimode Interference (MMI) devices, in configurations such as 1x2MMI, 2x2MMI, and 4x4MMI, are employed to split and combine light signals. An input signal may, e.g., be split into two output signals, and shifted in phase by a 90° Phase Shifter. Photodiodes (PD) are used to convert light signals into electrical signals. The signal processing typically involves using outputs separately, selectively, or by summing the output signals for determining the type of response.

An optical transceiver traditionally implements laser wavelength locking off-chip, and despite advancements in wavelength locking technology, the trend is moving towards on-chip wavelength locking for further monolithic integration. However, as miniaturization must not compromise functionality or performance, there is a need for new and improved wavelength lockers.

### Summary

A general objective is to provide an improved wavelength controller for a tunable laser, and a corresponding laser system comprising such a wavelength controller.

Herein, a wavelength controller is sometimes referred to as a wavelength locker (WLL).

A specific objective of the present description is to provide a WLL, preferably on-chip, for arbitrary wavelength locking, i.e. to lock a laser to any desired wavelength with minimal recalibration effort to offer improved flexibility in operation.

Another specific objective is to provide a high-accuracy and large-range WLL with an integrated laser, having a compact size and an easy assembly process which is facilitated through wire-bonding and does not require optical alignment.

A further objective is to provide a resource-efficient wavelength controller aiming to reduce the required amount of resources such as the number of photodiodes, thus contributing to cost-effectiveness and sustainability.

At least some of these and other objectives are at least partly met by the invention as defined in the independent claims. Preferred exemplifying embodiments are set out in the dependent claims.

According to an aspect, there is provided a wavelength controller for a tunable laser, wherein said wavelength controller is configured to receive an input signal and in response thereto generate a control signal for tuning the wavelength of said tunable laser, and wherein said wavelength controller includes: an interferometer-based circuit configured to generate phase-shifted intensity values based on said input signal; a vector-based signal synthesizer configured to generate a complex vector-based signal based on said phase-shifted intensity values and to compute at least one vector-representing quantity based on said complex vector-based signal, wherein said at least one vector-representing quantity is substantially linearly correlated with the wavelength; and a control signal generator configured to generate the control signal at least partly based on said at least one vector-representing quantity.

Hereby, a high performance wavelength controller and/or laser system is provided.

For example, improved control accuracy of wavelengths may be provided. In particular, the substantially linear correlation between the at least one vector-representing quantity and the wavelength, enables the wavelength controller to accurately lock the tunable laser for more wavelengths.

The enhanced accuracy of the wavelength controller leads to an improvement in performance of optical, or laser, systems in which it is used (e.g. wavelength lockers). Hence, clearer and more reliable signal transmission may be provided.

Further, due to the wavelength controller being able to lock more wavelengths accurately, increased performance and/or capacity is provided, e.g. allowing for more data to be transmitted. Thereby, efficiency is improved, meaning that systems or wavelength lockers incorporating the wavelength controller are more effective for high-speed data transmission applications.

In addition, accurate locking of wavelengths can help reduce interference between different wavelengths. Hence, signal degradation and loss of information may be reduced, ensuring that transmitted data is received intact at another end.

The wavelength controller may further be capable of handling any phase shift of the phase-shifted intensity values. Specifically, the phase shift may be of any non-zero angle strictly larger than -180 degrees and strictly smaller than +180 degrees. Thus greater flexibility in managing different signal conditions and enhanced robustness of the wavelength controller, e.g. against variations in signal properties, is provide.

Further, it is to be understood that the vector-representing quantity or quantities may be regarded as vector-defining characteristics.

In the context of this description, the meaning of two variables or quantities being "substantially linearly correlated" may imply that there is a strong degree of linear relationship between said variables or quantities. However, it may not necessarily imply a perfect linear relationship. There may be some degree of variation or deviation from a perfect straight line when the data is plotted on a graph. The term "substantially" is used to account for these minor variations that do not materially affect the overall linear correlation between the variables. Hence, it should be understood in light of the specific context provided in the description, claims, and drawings of the patent application that the term is clear and well-defined.

Alternatively, the at least one vector-representing quantity may be linearly correlated with the wavelength. Thus, any change in the wavelength may result in a directly proportional change in the vector-representing quantity, without any deviation.

According to an exemplifying embodiment, the at least one vector-representing quantity may include angle and/or amplitude of the complex vector-based signal. The angle and amplitude may also, respectively, be referred to as phase and magnitude/intensity of a complex signal. In other words, in the wavelength controller, wavelength information may be converted to a value of parameters such as intensity or angle.

According to another exemplifying embodiment, the control signal generator may be configured to perform control signal calculation based on the at least one vector-representing quantity. In other words, the control signal generator may be designed to perform calculations for generating control signals, e.g., where at least one quantity that represents a vector is used for these calculations. Essentially, the control signal generator may take the vector-representing quantity as an input to compute the control signals.

According to yet another exemplifying embodiment, the interferometer-based circuit may comprise a phase shifter for providing a phase shift when generating the phase-shifted intensity values. The phase shifter may be a thermal phase shifter which may be configured to induce a thermal phase shift. The thermal phase shifter may for example be a heater-based unipolar-to-bipolar converter.

The inclusion of the phase shifter in the interferometer-based circuit enhances control over the interference pattern produced by the interferometer. By adjusting the phase shift, the circuit may manipulate the resulting interference pattern.

Hence, through controlling the phase shift, facilitated locking for any wavelength digitally may be provided. In other words, the wavelength controller may provide the ability to easily adjust and lock onto any desired wavelength via the phase shifter using digital controls (e.g., increasing the heat of the heater).

According to another exemplifying embodiment, the interferometer-based circuit may comprise at least two different waveguides with different Free Spectral Range (FSR), including a first waveguide having a first FSR and a second waveguide having a second FSR, wherein the second FSR is larger than the first FSR to enable higher wavelength resolution for a signal through the first waveguide and larger wavelength correction range for a signal through the second waveguide.

In other words, the interferometer-based circuit may include at least two different waveguides, each with a different FSR. The difference in FSRs allows for a higher wavelength resolution for a signal passing through the first waveguide and a larger wavelength correction range for a signal passing through the second waveguide.

The combination of high resolution and large correction range makes the interferometer-based circuit more robust. For example, to increase accuracy (or wavelength resolution), a small FSR is required. However, the wavelength correcting range is within a period (2π), hence, when a wavelength shifts beyond an FSR, the calculated vector-based quantity may repeat, and such values may be indistinguishable. Thus, to enable both high accuracy and a large range, two FSRs (a small FSR for high accuracy and a larger FSR for the large locking range) may be implemented. In other words, by designing an integrating small-and-large FSR structures, the wavelength controller may achieve both high-frequency accuracy/resolution and a large correcting range.

According to still another exemplifying embodiment, the wavelength controller may further comprise an optical input switch for selectively feeding one of at least two different signals as the input signal of the wavelength controller.

Since the wavelength controller may act as a wavemeter (able to measure a single wavelength at a time, typically with high accuracy), the optical switch may be implemented such that comparing two wavelengths can be done efficiently.

The optical switch may alternatively, or additionally, be integrated into the interferometer-based circuit.

According to an exemplifying embodiment, the at least two different signals may include a transmitted (Tx) laser signal and a received (Rx) laser signal.

Hence, in combination with the optical switch, the optical switch may enable the ability to choose either the Rx- or the Tx-wavelength to be measured (where a typical suppression of the optical switch may be about -20 dB to -30 dB).

In an example, the control signal calculation (performed by the control signal generator) may involve comparing the laser wavelength (Tx) to a wavelength from another (Rx) source. A wavelength switch may be implemented such that the vector-representing quantity may be measured first for Rx, then for Tx, and lastly compared, where, if needed, the laser wavelength of Tx may be adjusted to match the wavelength of Rx.

According to another exemplifying embodiment, the wavelength controller may be configured to provide time-interleaved tracking of the transmitted (Tx) laser signal and the received (Rx) laser signal. In other words, if Tx and Rx are simultaneously fed into a single wavelength measuring structure, the wavelengths of Rx and Tx would not be distinguishable and could not be measured, hence, the wavelengths may instead be measured sequentially, i.e., time-interleaved.

Hereby, time-interleaved tracking of the transmitted (Tx) laser signal and the received (Rx) laser signal allows for sharing of a same light detection unit, and thus reducing complexity and costs as there is no need for separate detection units for the Tx and Rx signals. For example, a total number of PDs and/or other components may be halved.

According to an exemplifying embodiment, the wavelength controller may be configured to provide the time-interleaved tracking to enable reduction of a wavelength difference between the received (Rx) laser signal and a local oscillator signal (LO) and/or maintaining transmission laser stability of the transmitted (Tx) laser signal.

In other words, a wavelength difference between the received laser signal (Rx) and the local oscillator signal (LO) may be decreased, and the transmitted signal (Tx) may remain stable. Hence, near coherent receivers may be provided such that the Rx signal and the Tx local oscillator may be at a substantially same wavelength, and thereby coherently amplify the wavelength.

Thus, by reducing the wavelength difference between the received (Rx) and local oscillator (LO) signals, the wavelength controller may reduce potential interference and signal degradation, leading to clearer and more reliable signals. Further, by maintaining the stability of the transmitted signal (Tx), consistent performance the wavelength controller may be ensured. This could be particularly beneficial in applications where high precision and reliability are required, such as in telecommunications or data centers. Additionally, the time-interleaved tracking may allow for more efficient use of the available bandwidth, as signals may be more accurately targeted to specific wavelengths.

The local oscillator may be tuned, i.e. the local oscillator may comprise a laser which is tunable in wavelength. Depending on an accuracy of the RX signal, the local oscillator (i.e., Tx laser) may need a possibility to tune, e.g., over a range of about a few tens of GHz, up to a few hundreds of GHz. The tuning may be done, e.g., through external cavity tuning, via thermal tuning, and/or via current injection tuning.

According to another exemplifying embodiment, the interferometer-based circuit may comprise: a first signal divider configured to divide the input signal into two different signal paths, a first signal path and a second signal path; a second signal divider, in the first signal path, configured to divide a signal of the first signal path into two parts having the same phase; a third signal divider, in the second signal path, configured to divide a signal of the second signal path into two parts having different phases to provide a non-zero, relative phase shift; two signal combiners, each signal combiner being configured to perform signal combination based on an output of the second signal divider and a respective output of the third signal divider to provide a combined signal each; and two detectors, each detector being configured to detect an intensity value of the combined signal of a respective signal combiner, wherein the intensity values of the two detectors are phase shifted with respect to each other and provided as input to the vector-based signal synthesizer.

In other words, only two detectors (e.g., single-ended photo detectors) may be needed. Hence, fewer resources may be needed and a small footprint may be provided, thereby, also providing a lower technical difficulty.

According to a particular exemplifying embodiment, the first signal divider may be based on a 1x2 Multi-Mode Interferometer, MMI, and the second signal divider may be based on a 1x2 MMI, and the third signal divider may be based on a 2x2 MMI and each of the signal combiners may be based on a 2x1 MMI, and each of the detection units may be based on a photo detector.

MMIs such as 1x2 and 2x2 MMIs may be considered simple divergence components and may have smaller footprint and smaller component phase errors compared to other MMIs, resulting in a more compact and efficient design. Furthermore, 1x2 and 2x2 MMIs may provide broader bandwidth than larger MMIs.

As mentioned, the wavelength controller may be capable of handling any phase shift of the phase-shifted intensity values. Specifically, the phase shift may be of any non-zero angle strictly larger than -180 degrees and strictly smaller than +180 degrees. According to a particular exemplifying embodiment, the relative phase shift may be between 60 and 120 degrees. This provides good performance, e.g., with respect to Signal-to Noise Ratio (SNR). The relative phase shift may, e.g., be close to 90 degrees.

According to an exemplifying embodiment, a phase shifting-based unipolar-to-bipolar converter may be incorporated in the first signal path or the second signal path for providing a thermal phase shift when generating the phase-shifted intensity values.

A thermal phase shifter (e.g. phase shifting-based unipolar-to-bipolar converter) may provide an efficient phase change. Further, a smaller on-chip size compared to other phase shifters (e.g. PN junctions) may be provided.

According to an exemplifying embodiment, the wavelength controller may be configured to tune the wavelength to be within a limited wavelength region.

According to an exemplifying embodiment, the wavelength controller may be a wavelength locker (WLL).

According to an exemplifying embodiment, the wavelength controller may be integrated on the same integrated circuit as the laser. Thereby, reduced component size and ease of manufacturing is provided.

According to an exemplifying embodiment, the wavelength controller may be configured to receive at least part of an output of the tunable laser as said input signal, or configured to receive at least part of a received laser signal as said input signal. Hence, improved flexibility and capability of handling different types of input signals is provided.

The part of the output of the tunable laser (or of the local oscillator) received by the wavelength controller may for example be between 0.1% to 10%. The flexibility in the light output may enable the adaption to different electronics and photodiode sensitivities. For example, switching from 0.1% to 10% of the LO light may result in a power measurement by the photodiode that is two orders of magnitude higher. The at least part of the output may, e.g., be of an order such that sufficient light for proper measurement is provided, while preventing saturation of the photodiodes due to excessive light.

According to another aspect, there is provided a laser system comprising a tunable laser and a wavelength controller according to any of the preceding claims.

For example, the laser system may be regarded as a wavelength locker, especially when seen as a closed loop. In other words, a wavelength locker may comprise a tunable laser and a wavelength controller.

This aspect may generally present the same or corresponding advantages as the former aspect.

### Brief description of the drawings

The above, as well as additional objects, features, and advantages of the present description, will be better understood through the following illustrative and nonlimiting detailed description, with reference to the appended drawings. In the drawings like reference numerals will be used for like elements unless stated otherwise.
Fig. 1 is a schematic diagram illustrating an overview of a laser system having a tunable laser and an associated wavelength controller according to an embodiment.
Fig. 2 is a schematic diagram illustrating an example of an interferometer-based circuit according to an embodiment.
Fig. 3 is a schematic diagram illustrating another example of an interferometer-based circuit according to an embodiment.
Fig. 4 is a schematic diagram illustrating a particular example of an interferometer-based circuit according to an embodiment.
Fig. 5 is a schematic diagram illustrating an example of a wavelength controller according to an embodiment.
Fig. 6 is a schematic diagram illustrating an example of a laser system according to an embodiment.
Fig. 7 is a schematic diagram illustrating an example of a laser system according to an embodiment.
Fig. 8A is a schematic diagram illustrating an example of an interferometer-based circuit according to an embodiment.
Fig. 8B is a schematic diagram illustrating an example of the angle-to-wavelength relation for a waveguide having a smaller FSR and a waveguide having a relatively larger FSR.
Fig. 8C is a schematic diagram illustrating an example of the wavelength correction range for a given FSR.
Fig. 8D is a diagram schematically illustrating an example of how two different FSRs can be combined to provide a relatively larger correction range (large FSR) while maintaining a desirable accuracy (small FSR).
Fig. 9 is a schematic diagram illustrating another example of an interferometer-based circuit according to an embodiment.
Fig. 10 is a schematic diagram illustrating yet another example of an interferometer-based circuit according to an embodiment.
Fig. 11A is a schematic diagram illustrating an example of the frequency response of the outputs of the photo detectors of an interferometer-based circuit according to an embodiment.
Fig. 11B is a schematic diagram illustrating intensity-to-frequency curves of the photo detectors corresponding to Fig. 11A.
Fig. 11C is a schematic diagram illustrating a substantially linear angle-to-frequency curve corresponding to Fig. 11B when vector synthesis has been performed.
Fig. 12 is a schematic diagram of an intensity-to-frequency curve showing how a wavelength shift can be introduced by applying a specific voltage to a phase shifter.

### Detailed description

The proposed technology will now be described with reference to various exemplifying embodiments.

As previously indicated, the proposed technology relates to a wavelength controller for a tunable laser, and a corresponding laser system.

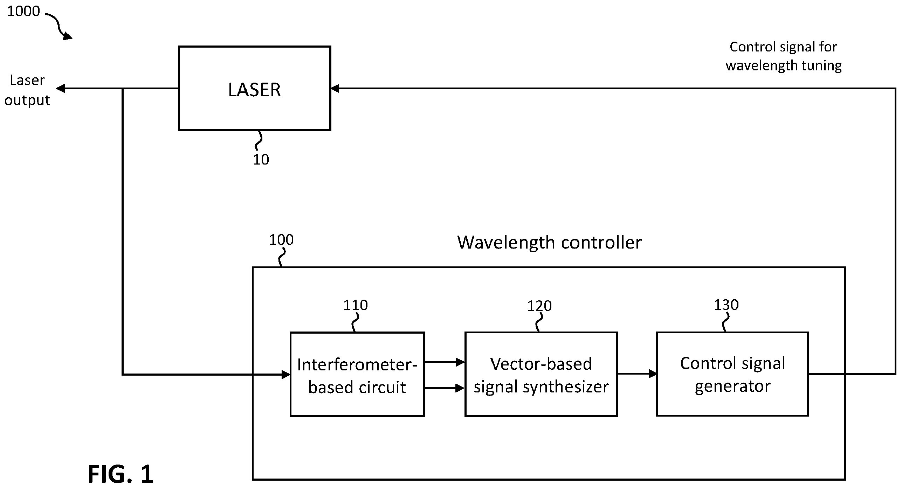

Fig. 1 is a schematic diagram illustrating an overview of a laser system 1000 having a tunable laser 10 and an associated wavelength controller 100 according to an embodiment.

The wavelength controller 100 is configured to receive an input signal and in response thereto generate a control signal for tuning the wavelength of the tunable laser. In this particular example, the wavelength controller 100 is configured to receive at least part of the output of the laser 10 as an input signal.

The wavelength controller 100 includes an interferometer-based circuit 110 configured to generate phase-shifted intensity values based on the input signal. The wavelength controller 100 further includes a vector-based signal synthesizer 120 configured to generate a complex vector-based signal based on the phase-shifted intensity values and to compute at least one vector-representing quantity based on the complex vector-based signal. The vector-representing quantity or quantities is/are substantially linearly correlated with the wavelength. The wavelength controller 100 also includes a control signal generator 130 configured to generate the control signal at least partly based on said at least one vector-representing quantity.

Hereby, a high performance wavelength controller and/or laser system is provided. For example, improved laser stability control is achieved with high accuracy for all or at least a larger range of wavelengths compared to conventional solutions.

In particular, the wavelength controller may contain wavelength-sensitive elements that may translate wavelength into, for example, phase, and information of said phase may be used for laser stability control, where it is appreciated that wavelength locking may here be achieved without any need for active optical control mechanisms, such as active optical phase shifting.

By way of example, the wavelength controller may be integrated on the same integrated circuit as the laser, e.g., a photonic integrated chip (PIC).

In other words, there is provided a wavelength controller suitable for an integrated WLL that can create a linear wavelength feedback for laser stability control with the same high accuracy for all wavelengths. The linear wavelength feedback may, for example, be created by constructing a complex vector-based signal (R+j*Q) with the help of two (cost-efficient and/or low-speed) photodiodes and relative photonic circuits.

After initialization/calibration, the tunable laser may be locked to any position within a broad spectrum of wavelengths. The broad spectrum may include, but is not limited to, C- and L-bands, where the C-band (Conventional Band) ranges from 1530 nm to 1565 nm and the L-band (Long-wavelength Band) ranges from 1565 nm to 1625 nm.

The term 'locked' in this context refers to the laser's ability to maintain a stable output at a specific wavelength.

Further, it is to be understood that the vector-representing quantity or quantities may be regarded as vector-defining characteristics.

In the context of this description, the meaning of two variables or quantities being "substantially linearly correlated" may imply that there is a strong degree of linear relationship between said variables or quantities. However, it may not necessarily imply a perfect linear relationship. There may be some degree of variation or deviation from a perfect straight line when the data is plotted on a graph. The term "substantially" is used to account for these minor variations that do not materially affect the overall linear correlation between the variables. Hence, it should be understood in light of the specific context provided in the description, claims, and drawings of the patent application that the term is clear and well-defined.

Alternatively, the at least one vector-representing quantity may be linearly correlated with the wavelength. Thus, any change in the wavelength may result in a directly proportional change in the vector-representing quantity, without any deviation.

According to an exemplifying embodiment, the at least one vector-representing quantity may include angle and/or amplitude of the complex vector-based signal. The angle and amplitude may also, respectively, be referred to as phase and magnitude/intensity of a complex signal. In other words, in the wavelength controller, wavelength information may be converted to a value of parameters such as intensity or angle.

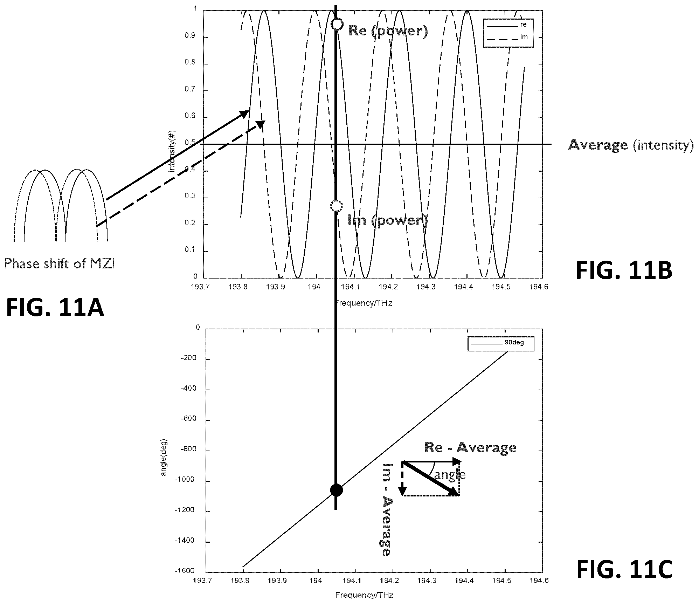

As mentioned above, the linear wavelength feedback may be created by constructing a complex vector-based signal (R+j*Q), e.g., with the help of two photodiodes and relative photonic circuits. Hence, for a given wavelength, the intensities of the two photodiodes may be used as part of real (Re) and imaginary (Im) components of the complex vector based signal, respectively. Reference can be made to Figs. 11A-C, which will be described in more detail later on. A composed complex value may be constructed as (Re - Calibration_average) + j*(Im - Calibration_average), where Calibration_average is the average value that can be calculated in WLL calibration. Thus, two-signal vector synthesis may be used, i.e. two signals may be combined to create a complex output. The angle of the complex vector-based signal may be calculated through sweeping through different wavelengths such that a linear angle-wavelength curve may be obtained. Both, or either, of the angle and amplitude of the complex vector-based signal may linearly correlated with the wavelength.

Hereby, thanks to the linear correlation between the angle (and/or amplitude) and the wavelength, there is provided a wavelength controller with equal resolution for any wavelength of the tunable laser. Further, the linearity provides the ability to lock onto any wavelength within the tunable laser's operating range, with no dead locking range (i.e., no dead zones or ranges where the wavelength controller cannot lock onto a certain wavelength).

The proposed circuit designs, which will be discussed herein, may offer additional advantages such as a smaller footprint, smaller component phase errors, simpler on-chip components, improved fabrication tolerance, easier phase error compensation and so forth compared to conventional circuit designs.

According to another exemplifying embodiment, the control signal generator may be configured to perform control signal calculation based on the at least one vector-representing quantity. In other words, the control signal generator may be designed to perform calculations for generating control signals, e.g., where at least one quantity that represents a vector is used for these calculations. Essentially, the control signal generator may take the vector-representing quantity as an input to compute the control signals.

The control signal calculation may be a delta value calculation. For example, for a given wavelength, there may be a corresponding value of the vector-representing quantity (e.g., angle), and when the wavelength shifts, another value of the vector-representing quantity may be obtained. Hence, the calculated delta value may be the difference (e.g., absolute difference) between the value of a vector-representing quantity for two different wavelengths. In other words, only measuring the wavelength of the laser itself, the delta value may be calculated by comparing the vector-representing quantity of a measured wavelength with the vector-representing quantity of a previously measured wavelength.

The delta value may in turn be used as feedback information to tune, control, and/or lock the laser's wavelength. However, the delta value may further be used to, e.g., calculate a delta signal over time for further signal processing involving any well-accepted control procedure such as Proportional - Integral - Derivative (PID) regulation.

According to yet another exemplifying embodiment, the interferometer-based circuit may comprise a phase shifter for providing a phase shift when generating the phase-shifted intensity values. By way of example, the phase shifter may be a thermal phase shifter which may be configured to induce a thermal phase shift. The thermal phase shifter may for example be a heater-based unipolar-to-bipolar converter.

The inclusion of the phase shifter in the interferometer-based circuit enhances control over the interference pattern produced by the interferometer. By adjusting the phase shift, the circuit may manipulate the resulting interference pattern.

Hence, through controlling the phase shift, facilitated locking for any wavelength digitally may be provided. In other words, the wavelength controller may provide the ability to easily adjust and lock onto any desired wavelength via the phase shifter using digital controls (e.g., increasing the heat of the heater).

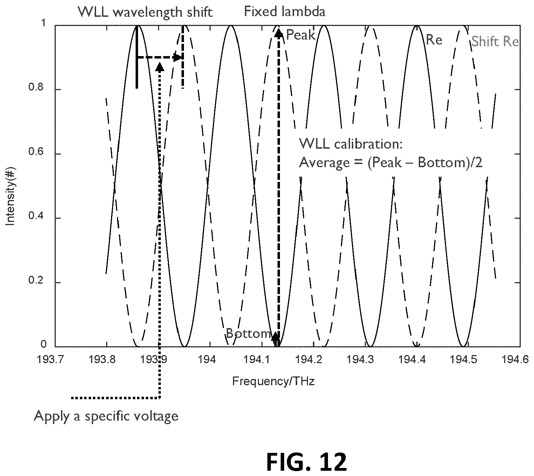

A metal (i.e. heater) of a thermal phase shifter may be supplied with different voltages/currents such that the metal will heat up a waveguide thereof to change the index of the waveguide, and thus change the phase of the light, e.g., see Fig. 12.

Fig. 12 is a schematic diagram of an intensity-to-frequency curve showing how a wavelength shift can be introduced by applying a specific voltage to a phase shifter. Thereby, by applying different voltages, different wavelength shifts can be achieved.

For example, during calibration, a fixed laser (i.e. no wavelength change) may be obtained by retrieving the maximum power (peak power of the Sinus wave in Fig. 12) and the minimum power (bottom power of the Sinus wave) by tuning the phase shifter. Further, in a working mode, an average value of the maximum and minimum powers may be used to convert unipolar photodiode currents into bipolar signals. Hence, an average intensity of the detected maximum and minimum powers can be obtained for a unipolar-to-bipolar conversion.

Further, a thermal phase shifter (on-chip) may be efficient to change phases with low insertion loss, such as up to tuning with 22 kHz. However, for high-speed tuning (e.g., above 1 MHz), non-thermal phase shifters (such as stress-optic phase shifting and/or electro-optic phase shifting) may be used to provide phase shifts.

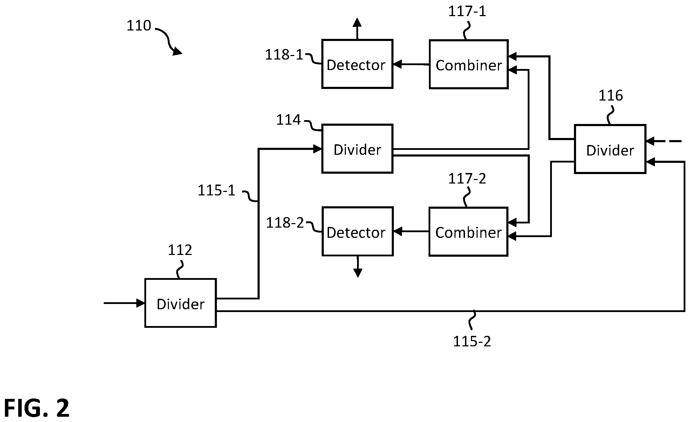

Fig. 2 is a schematic diagram illustrating an example of an interferometer-based circuit according to an embodiment.

In the example of Fig. 2, the interferometer-based circuit comprises a first signal divider 112 configured to divide the input signal into two different signal paths, a first signal path 115-1 and a second signal path 115-2; a second signal divider 114, in the first signal path, configured to divide a signal of the first signal path into two parts having the same phase; a third signal divider 116, in the second signal path, configured to divide a signal of the second signal path into two parts having different phases to provide a non-zero, relative phase shift; two signal combiners 117-1, 117-2, each signal combiner being configured to perform signal combination based on an output of the second signal divider 114 and a respective output of the third signal divider 116 to provide a combined signal each; and two detectors 118-1, 118-2, each detector being configured to detect an intensity value of the combined signal of a respective signal combiner 117-1, 117-2, wherein the intensity values of the two detectors 118-1, 118-2 are phase shifted with respect to each other and provided as input to the vector-based signal synthesizer (not shown in Fig. 2).

In other words, only two detectors (e.g., single-ended photo detectors) may be needed. Hence, fewer resources may be needed and a small footprint may be provided, thereby, also providing a lower technical difficulty.

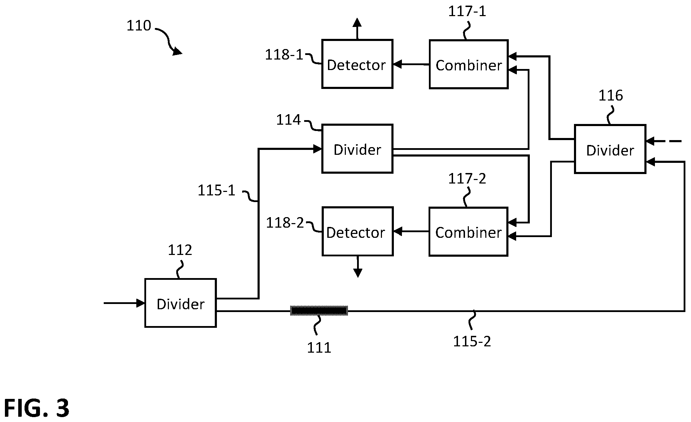

Fig. 3 is a schematic diagram illustrating another example of an interferometer-based circuit according to an embodiment. The example of Fig. 3 is similar to the example of Fig. 2, but with the inclusion of a phase shifter 111 in the second signal path 115-2 for providing a phase shift when generating the phase-shifted intensity values. As previously discussed, the phase shifter may be a thermal phase shifter which may be configured to induce a thermal phase shift. The thermal phase shifter may for example be a heater-based unipolar-to-bipolar converter. It should be understood that the phase shifter may be incorporated in the first signal path 115-1 or the second signal path 115-2 for providing a thermal phase shift when generating the phase-shifted intensity values.

The phase shifter 111 allows for control of the phase by altering the optical path length. When the light is recombined, for instance in a combiner such as 117-2, interference occurs. This interference is dependent on the additional time the light spent in the signal path, specifically the second signal path 115-2 in Fig. 3. The change in the optical path length may for example be around 1 µm (or maximum 1 µm). Consequently, the time shift may equate to a phase shift.

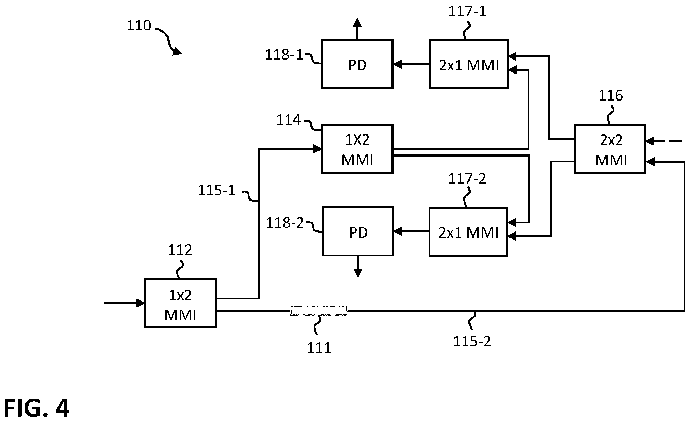

Fig. 4 is a schematic diagram illustrating a particular example of an interferometer-based circuit according to an embodiment. In this example, the first signal divider 112 is based on a 1x2 Multi-Mode Interferometer, MMI, and the second signal divider 114 is based on a 1x2 MMI, and the third signal divider 116 is based on a 2x2 MMI and each of the signal combiners 117-1, 117-2 is based on a 2x1 MMI, and each of the detection units 118-1, 118-2 is based on a photo detector (PD).

Further, Fig. 4 shows an optional inclusion of a phase shifter 111 in the second signal path 115-2.

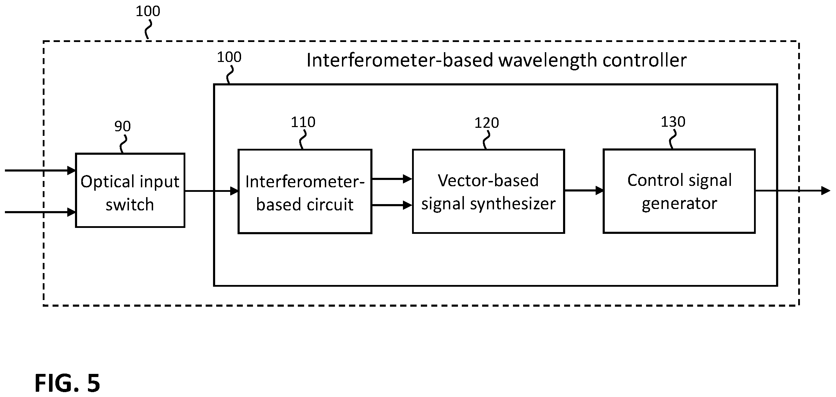

Fig. 5 is a schematic diagram illustrating an example of a wavelength controller according to an embodiment.

In this example, the wavelength controller may further comprise an optical input switch 90 for selectively feeding one of at least two different signals as the input signal of the wavelength controller 100.

Since the wavelength controller may act as a wavemeter (able to measure a single wavelength at a time, with high accuracy), the optical switch may be implemented such that comparing two wavelengths can be done efficiently.

The optical switch may alternatively, or additionally, be integrated into the interferometer-based circuit, as schematically indicated by the dashed lines in Fig. 5.

According to an exemplifying embodiment, the at least two different signals may include a transmitted (Tx) laser signal and a received (Rx) laser signal.

Hence, in combination with the optical switch, the optical switch may enable the ability to choose either the Rx- or the Tx-wavelength to be measured (where a typical suppression of the optical switch may be about -20 dB to -30 dB).

In an example, the control signal calculation (performed by the control signal generator) may involve comparing the laser wavelength (Tx) to a wavelength from another (Rx) source. A wavelength switch may be implemented such that the vector-representing quantity may be measured first for Rx, then for Tx, and lastly compared, where, if needed, the laser wavelength of Tx may be adjusted to match the wavelength of Rx.

According to another exemplifying embodiment, the wavelength controller may be configured to provide time-interleaved tracking of the transmitted (Tx) laser signal and the received (Rx) laser signal. In other words, if Tx and Rx are simultaneously fed into a single wavelength measuring structure, the wavelengths of Rx and Tx would not be distinguishable and could not be measured, hence, the wavelengths may instead be measured sequentially, i.e., time-interleaved.

Hereby, time-interleaved tracking of the transmitted (Tx) laser signal and the received (Rx) laser signal allows for sharing of a same light detection unit, and thus reducing complexity and costs as there is no need for separate detection units for the Tx and Rx signals. For example, a total number of PDs and/or other components may be halved.

According to an exemplifying embodiment, the wavelength controller may be configured to provide the time-interleaved tracking to enable reduction of a wavelength difference between the received (Rx) laser signal and a local oscillator signal (LO) and/or maintaining transmission laser stability of the transmitted (Tx) laser signal.

In other words, a wavelength difference between the received laser signal (Rx) and the local oscillator signal (LO) may be decreased, and the transmitted signal (Tx) may remain stable. Hence, near coherent receivers may be provided such that the Rx signal and the Tx local oscillator may be at a substantially same wavelength, and thereby coherently amplify the wavelength.

Thus, by reducing the wavelength difference between the received (Rx) and local oscillator (LO) signals, the wavelength controller may reduce potential interference and signal degradation, leading to clearer and more reliable signals. Further, by maintaining the stability of the transmitted signal (Tx), consistent performance the wavelength controller may be ensured. This could be particularly beneficial in applications where high precision and reliability are required, such as in telecommunications or data centers. Additionally, the time-interleaved tracking may allow for more efficient use of the available bandwidth, as signals may be more accurately targeted to specific wavelengths.

The local oscillator may be tuned, i.e. the local oscillator may comprise a laser which is tunable in wavelength. Depending on an accuracy of the RX signal, the local oscillator (i.e., Tx laser) may need a possibility to tune, e.g., over a range of about a few tens of GHz, up to a few hundreds of GHz. The tuning may be done, e.g., through external cavity tuning, via thermal tuning, and/or via current injection tuning.

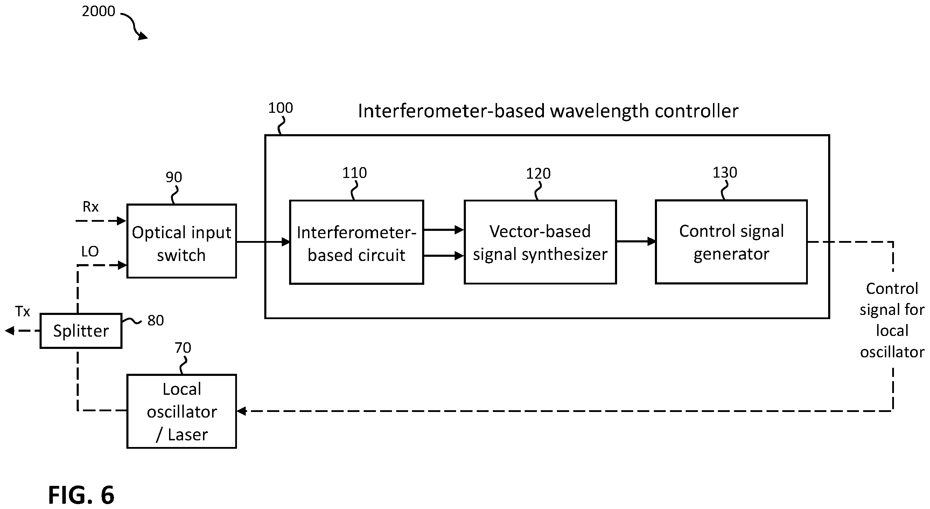

Fig. 6 is a schematic diagram illustrating an example of a laser system according to an embodiment. In this example, a laser is used as a local oscillator (LO) 70, and a splitter 80 is configured to split a small part of the laser output into a separate branch for LO feedback into the optical input switch 90.This provides the possibility to match LO and RX, and the wavelength of the TX wavelength of the laser 70 may also be changed or adjusted.

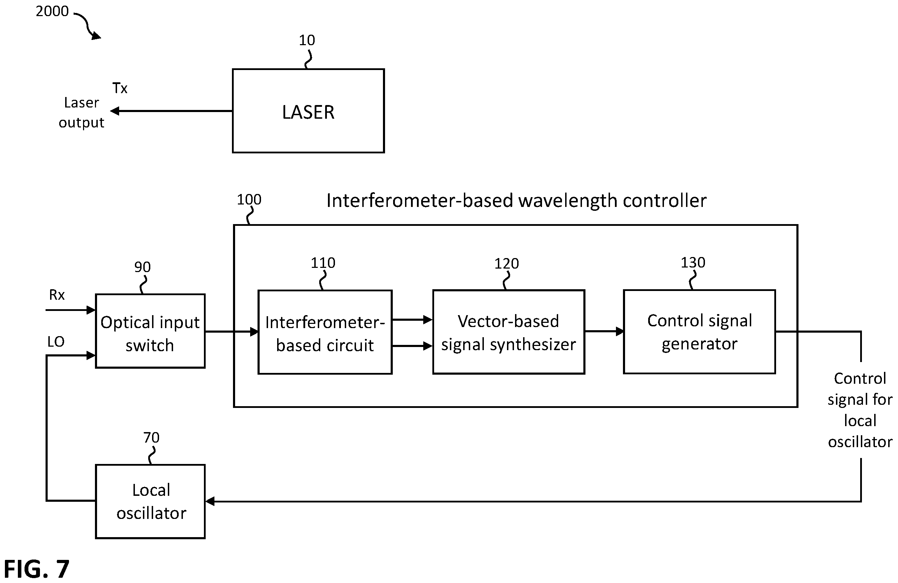

Fig. 7 is a schematic diagram illustrating an example of a laser system according to an embodiment. In this example, two separate lasers may be used, a transmission (Tx) laser 10 that is kept as stable as possible (without any feedback to/from the wavelength controller 100) and a local oscillator (LO) 70, which basically is a separate laser that can be tuned by using the wavelength controller 100. For example, it would be possible to measure the output of the local oscillator 70 and adjust the LO wavelength to match (or at least be relatively close to) the Rx wavelength of a received signal.

According to another exemplifying embodiment, the interferometer-based circuit may comprise at least two different waveguides with different Free Spectral Range (FSR), including a first waveguide having a first FSR and a second waveguide having a second FSR, wherein the second FSR is larger than the first FSR to enable higher wavelength resolution for a signal through the first waveguide and larger wavelength correction range for a signal through the second waveguide.

In other words, the interferometer-based circuit may include at least two different waveguides, each with a specific FSR. The difference in FSRs allows for a higher wavelength resolution for a signal passing through the first waveguide and a larger wavelength correction range for a signal passing through the second waveguide.

The combination of high resolution and large correction range makes the interferometer-based circuit more robust. For example, to increase accuracy (or wavelength resolution), a small FSR is required. However, the wavelength correcting range is normally within a period (2π), hence, when a wavelength shifts beyond an FSR, the calculated vector-based quantity may repeat, and such values may be indistinguishable. Thus, to enable both high accuracy and a large range, two FSRs (a small FSR for high accuracy and a larger FSR for the large locking range) may be implemented. In other words, by designing an integrating small-and-large FSR structures, the wavelength controller may achieve both high-frequency accuracy/resolution and a large correcting range.

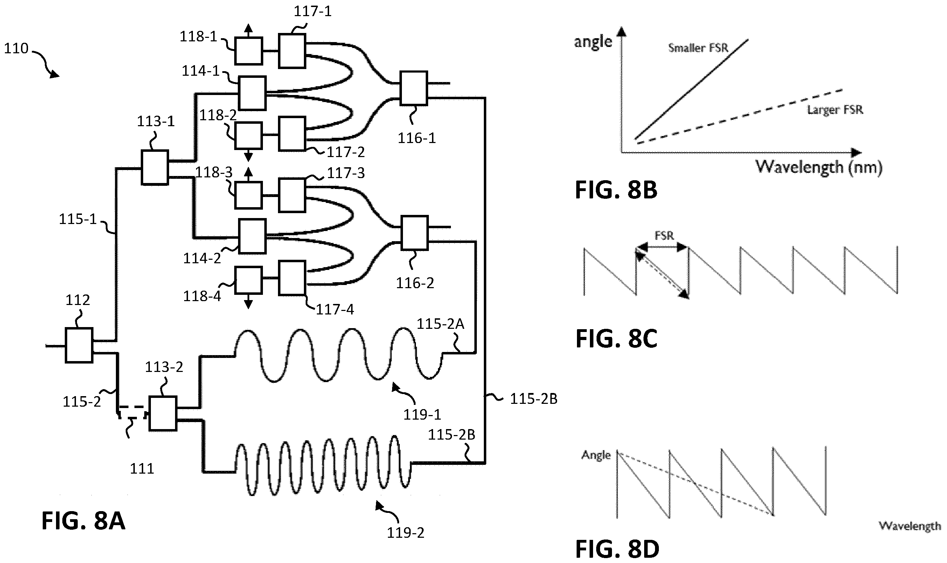

Fig. 8A is a schematic diagram illustrating an example of an interferometer-based circuit according to an embodiment. In the example of Fig. 8A, part of the basic interferometer circuitry of Figs. 2-4 is duplicated and integrated for use with different waveguides. As can be seen in the example of Fig. 8A, the interferometer-based circuit 110 further comprises two additional signal dividers 113-1, 113-2, another signal divider 114-2, and another signal divider 116-2, as well as two additional signal combiners 117-3, 117-4 and two more detectors 118-3, 118-4.

Basically, the second signal path 115-2 comprises an additional divider 113-2, arranged upstream of the signal dividers 116-1, 116-2 for dividing a signal of the second signal path 115-2 into a first waveguide 119-1 (corresponding to signal path 115-2A) having a first FSR and a second waveguide 119-2 (corresponding to signal path 115-2B) having a second FSR, wherein the second FSR is larger than the first FSR, to enable higher wavelength resolution for a signal through the first waveguide 119-1 and larger wavelength correction range for a signal through the second waveguide 119-2. Alternatively, the FSR of the first waveguide 119-1 may be larger than the FSR of the second waveguide 119-2.

However, in Fig. 8, the second waveguide 119-2 with a large FSR is designed to measure the wavelength coarsely, while the first waveguide 119-1 with a small FSR is responsible for measuring the wavelength with high precision. However, the small FSR does not have a wide range, meaning that the absolute wavelength may be unknown.

For instance, in a particular example, if the wavelength to be measured is exactly 1550 nm, two interferometers are used, one with an FSR of 100 nm and the other with an FSR of 1 nm. The interferometer with an FSR of 100 nm provides a rough estimate of the wavelength at 1550 +/- 0.5 nm. The second interferometer can then accurately determine whether the wavelength within the interval of 1550 +/- 0.5 nm, such as determining the wavelength to be 1550.03 nm. Conversely, if only the second interferometer with an FSR of 1 nm is used, it may not be possible to differentiate between the wavelength being 1550.03 nm, 1551.03 nm, 1552.03 nm, etc. Thus, measuring the coarse range, the accurate wavelength can be pinpointed. Hence, both coarse and precise wavelength control is provided.

Fig. 8B is a schematic diagram illustrating an example of the angle-to-wavelength relation for a waveguide having a smaller FSR and a waveguide having a relatively larger FSR.

Fig. 8C is a schematic diagram illustrating an example of the wavelength correction range for a given FSR.

Fig. 8D is a diagram schematically illustrating an example of how two different FSRs can be combined to provide a relatively larger correction range (large FSR) while maintaining a desirable accuracy (small FSR).

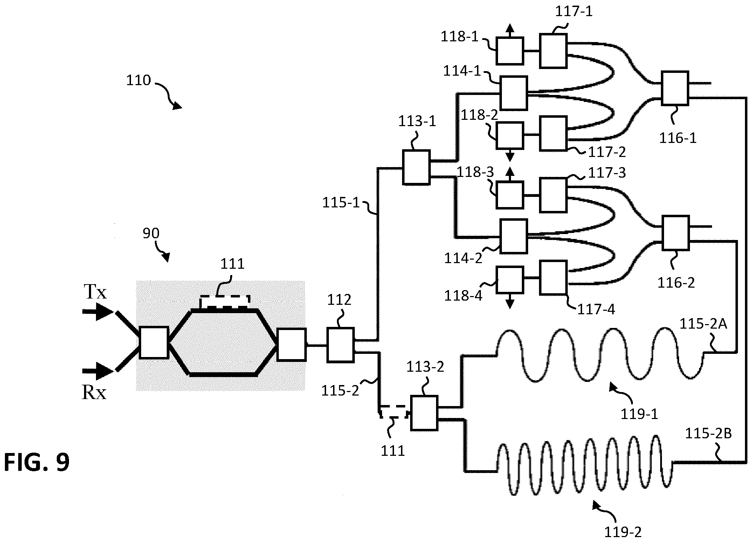

Fig. 9 is a schematic diagram illustrating another example of an interferometer-based circuit according to an embodiment. Fig. 9 is similar to Fig. 8, except for an additional input switch that is present in the circuit solution shown in Fig. 9. To address coherent applications, an alternative design is proposed by introducing an extra optical switch, which allows Tx or Rx signal feeding into the WLL with time-division-multiplexing mode as previously discussed. This means that Tx and Rx may share the same WLL structure and individual feedback loops may be created using the switch 90 to maintain Tx laser stability and keep Rx-LO frequency small, separately. By way of example, the switch 90 may be a Mach-Zehnder (MZ) based switch with an optional internal phase shifter 111 integrated therein.

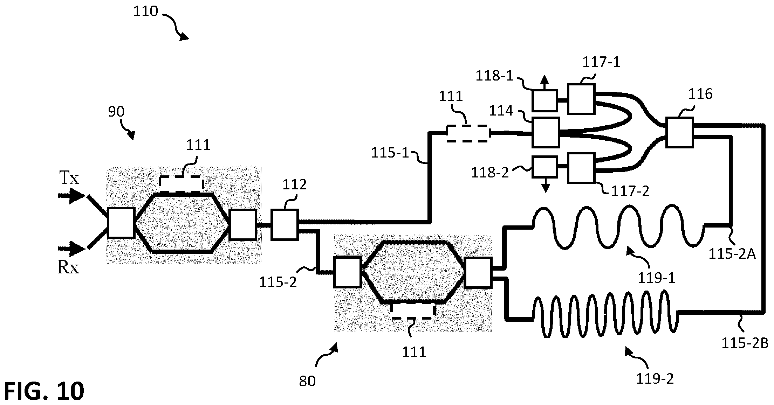

Fig. 10 is a schematic diagram illustrating yet another example of an interferometer-based circuit according to an embodiment. This represents an alternative embodiment for implementing different waveguides, by using an optical switch 80. In this example, the second signal path 115-2 comprises an optical switch 80, arranged upstream of the signal divider 116, for switching between a first waveguide 119-1 having a first Free Spectral Range (FSR) and a second waveguide 119-2 having a second FSR, wherein the second FSR is larger than the first FSR, to enable higher wavelength resolution for a signal through the first waveguide 119-1 and larger wavelength correction range for a signal through the second waveguide 119-2. For example, the switch 80 may be a MZ-based switch with an optional internal phase shifter 111 integrated therein.

Fig. 11A is a schematic diagram illustrating an example of the frequency response of the outputs of the photo detectors of an interferometer-based circuit according to an embodiment.

Fig. 11B is a schematic diagram illustrating intensity-to-frequency curves of the photo detectors corresponding to Fig. 11A.

Fig. 11C is a schematic diagram illustrating a substantially linear angle-to-frequency curve corresponding to Fig. 11B when vector synthesis has been performed.

By way of example, for a given wavelength, the intensity values of the photo detectors can be determined and used as part of real (Re) and imagine (Im) components of a new-constructed complex signal, respectively. Composed complex value of (Re-CAL_aver) + j*(Im- CAL_aver). Here CAL_aver is an average value that can be calculated in WLL calibration. Calculate the angle of complex signal with sweeping frequency/wavelength as shown in Fig. 11C, then a linear angle-to-frequency/wavelength curve could be obtained.

Thus, two-signal vector synthesis may be used, i.e., two signals may be combined to create a complex output. The angle of the complex vector-based signal may be calculated through sweeping through different wavelengths such that a linear angle-wavelength curve may be obtained. Both, or either, of the angle and amplitude of the complex vector-based signal may linearly correlated with the wavelength.

Hereby, thanks to the linear correlation between the angle (and/or amplitude) and the wavelength, there is provided a wavelength controller with equal resolution for any wavelength of the tunable laser. Further, the linearity provides the ability to lock onto any wavelength within the tunable laser's operating range, with no dead locking range (i.e., no dead zones or ranges where the wavelength controller cannot lock onto a certain wavelength).

In the above, the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A wavelength controller (100) for a tunable laser (10),
wherein said wavelength controller (100) is configured to receive an input signal and in response thereto generate a control signal for tuning the wavelength of said tunable laser (10), and wherein said wavelength controller (100) includes:
- an interferometer-based circuit (110) configured to generate phase-shifted intensity values based on said input signal;
- a vector-based signal synthesizer (120) configured to generate a complex vector-based signal based on said phase-shifted intensity values and to compute at least one vector-representing quantity based on said complex vector-based signal, wherein said at least one vector-representing quantity is substantially linearly correlated with the wavelength; and
- a control signal generator (130) configured to generate the control signal at least partly based on said at least one vector-representing quantity.

2. The wavelength controller (100) of claim 1, wherein said at least one vector-representing quantity includes angle and/or amplitude of said complex vector-based signal.

3. The wavelength controller (100) of claim 1 or 2, wherein said control signal generator (130) is configured to perform control signal calculation based on said at least one vector-representing quantity.

4. The wavelength controller (100) of any of the preceding claims, wherein the interferometer-based circuit (110) comprises a phase shifter (111) for providing a phase shift when generating the phase-shifted intensity values.

5. The wavelength controller (100) of any of the preceding claims, wherein the interferometer-based circuit (110) comprises at least two different waveguides (119-1, 119-2) with different Free Spectral Range (FSR), including a first waveguide (119-1) having a first FSR and a second waveguide (119-2) having a second FSR, wherein the second FSR is larger than the first FSR to enable higher wavelength resolution for a signal through the first waveguide (119-1) and larger wavelength correction range for a signal through the second waveguide (119-2).

6. The wavelength controller (100) of any of the preceding claims, further comprising an optical input switch (90) for selectively feeding one of at least two different signals as the input signal of said wavelength controller (100).

7. The wavelength controller (100) of claim 6, wherein said at least two different signals include a transmitted (Tx) laser signal and a received (Rx) laser signal.

8. The wavelength controller (100) of claim 7, wherein said wavelength controller (100) is configured to provide time-interleaved tracking of the transmitted (Tx) laser signal and the received (Rx) laser signal.

9. The wavelength controller (100) of claim 8, wherein said wavelength controller (100) is configured to provide said time-interleaved tracking to enable reduction of a wavelength difference between the received (Rx) laser signal and a local oscillator (70) signal and/or maintaining transmission laser stability of the transmitted (Tx) laser signal.

10. The wavelength controller (100) of any of the preceding claims, wherein the interferometer-based circuit (110) comprises:
- a first signal divider (112) configured to divide the input signal into two different signal paths (115-1, 115-2), a first signal path (115-1) and a second signal path (115-2);
- a second signal divider (114), in the first signal path (115-1), configured to divide a signal of the first signal path (115-1) into two parts having the same phase;
- a third signal divider (116), in the second signal path (115-2), configured to divide a signal of the second signal path (115-2) into two parts having different phases to provide a non-zero, relative phase shift;
- two signal combiners (117-1, 117-2), each signal combiner (117-1, 117-2) being configured to perform signal combination based on an output of the second signal divider (114) and a respective output of the third signal divider (116) to provide a combined signal each; and
- two detectors (118-1, 118-2), each detector (118-1, 118-2) being configured to detect an intensity value of the combined signal of a respective signal combiner (117-1, 117-2), wherein the intensity values of the two detectors (118-1, 118-2) are phase shifted with respect to each other and provided as input to the vector-based signal synthesizer (120).

11. The wavelength controller (100) of claim 10, wherein the first signal divider (112) is based on a 1x2 Multi-Mode Interferometer, MMI, and the second signal divider (114) is based on a 1x2 MMI, and the third signal divider (116) is based on a 2x2 MMI and each of the signal combiners (117-1, 117-2) is based on a 2x1 MMI, and each of the detection units (118-1, 118-2) is based on a photo detector.

12. The wavelength controller (100) of claim 10 or 11, wherein the relative phase shift is between 60 and 120 degrees.

13. The wavelength controller (100) of any of the claims 10 to 12, wherein a phase shifting-based unipolar-to-bipolar converter (111) is incorporated in the first signal path (115-1) or the second signal path (115-2) for providing a thermal phase shift when generating the phase-shifted intensity values.

14. The wavelength controller (100) of any of the preceding claims, wherein said wavelength controller (100) is configured to tune the wavelength to be within a limited wavelength region.

15. The wavelength controller (100) of any of the preceding claims, wherein said wavelength controller (100) is a wavelength locker (WLL).

16. The wavelength controller (100) of any of the preceding claims, wherein said wavelength controller (100) is integrated on the same integrated circuit as the laser (10).

17. The wavelength controller (100) of any of the preceding claims, wherein said wavelength controller (100) is configured to receive at least part of an output of said tunable laser (10) as said input signal, or configured to receive at least part of a received laser signal as said input signal.

18. A laser system (1000) comprising a tunable laser (10) and a wavelength controller (100) according to any of the preceding claims.
